# EUROPEAN PATENT SPECIFICATION

(11) **EP 2 175 459 B1**
(45) Date of publication and mention of the grant of the patent: **25.07.2012**
(21) Application number: 08017859.3
(22) Date of filing: 11.10.2008
(51) Int. Cl.: H01F 7/18, B23Q 3/154, G01R 31/06

(54) **Method to operate a control device for energising at least one coil of a permanently magnetisable chuck and corresponding control device**
Verfahren zur Bedienung einer Steuervorrichtung zur Erregung von mindestens einer Spule eines permanent magnetisierbaren Spannfutters und entsprechende Steuervorrichtung
Procédé de fonctionnement d'un dispositif de contrôle pour alimenter au moins une bobine d'un mandrin magnétisable en permanence et son dispositif de contrôle

(43) Date of publication of application: 14.04.2010
(73) Proprietor: Schunk GmbH & Co. KG Spann- und Greiftechnik, 74348 Lauffen am Neckar (DE)
(72) Inventor: Vicentelli, Paolo, 20081 Abbiategrassi (MI) (IT); Fiolsa, Giuseppe, 24043 Caravaggio-BG (IT); Oliveri, Giuseppe, 74078 Heilbronn (DE); Fellhauer, Bruno, 74336 Brackenheim (DE)
(74) Representative: Dreiss

(56) References cited:
- EP-A- 0 854 408
- DE-A1- 3 922 900
- GB-A- 2 069 259
- US-A- 4 746 869
- US-A- 5 638 247

## Description

The present invention refers to a method to operate a control device for energising at least one coil of a permanently magnetisable chuck to modify a magnetisation of the chuck, wherein the control device comprises an electrical connection having at least one conductor to connect power supply circuitry of the control device with the coil, the method comprising energising the coil by means of said power supply circuitry to modify the magnetisation.

Permanently magnetisable chucks are typically installed on machine tools such as milling machines, CNC machine centres, tuning machines, and the like. They serve to magnetically fixate a work piece or a work piece holder relative to the machine tools.

A permanently magnetisable chuck can be set in a magnetised state by temporarily energising the coil. After the energising has been completed the chuck maintains its magnetised state so that the work piece or the work piece holder can be fixed on the chuck without the need to provide a constant power supply to the chuck. In order to demagnetise the chuck the coil can be energised a second time. After the chuck has been demagnetised the work piece or the work piece holder can be easily removed from the chuck. Usually, the energising comprises applying electrical pulses to the coil, wherein a procedure used to magnetise the chuck differs from a procedure to demagnetise the chuck.

As energising the coil of the chuck is only required to change the magnetisation, i. e. to magnetise or to demagnetise the chuck, the connection between the control device and the chuck often comprises a connector so that a single control device can be used to operate multiple chucks.

However, using the connector introduces an increased risk that the connection between the control device and the chuck is faulty. For instance, metallic chips can accidentally be inserted into the connector causing a short-circuit between conductors of the connector. A faulty connection can lead to short circuits and/or to damage of the control device or the chuck. It is even possible that operating personal might be subjected to a high voltage generated by the control device due to the faulty connection. Moreover, a risk of damage of the control device or the chuck and the danger to the operating personnel can also result from a defective part such as a relay or a thyristor within the control device or the chuck.

The published patent application EP 0 854 408 A2 discloses an electromagnet with a power supply. The power supply has a controller and a current sensor for measuring a current flowing through the electromagnet. The controller and the current sensor are arranged for providing an overcurrent protection for the electromagnet.

The patent US 5,991,147 discloses a magnetizing-demagnetizing circuit connected to an electromagnetic chuck. This circuit comprises an overcurrent protection circuit for achieving an overcurrent protection for the magnetizing/demagnetizing circuit.

The document GB 2 069 259 A discloses a method according to the preamble of claim 1.

An overcurrent protection as known in the art cannot avoid the problems caused by a faulty connection or defective parts because a maximum current needed to energise the coil is very high and a cut-off current of overcurrent protection means cannot be chosen low enough to achieve a sufficient protection of the operating personal, the control device and the chuck.

Accordingly, the object of the present invention is to provide a method to operate a control device for energising a coil of a permanently magnetisable chuck which is safe and protects the control device and/or the chuck from being damaged due to a faulty connection between the control device and the chuck.

According to the present invention this object is achieved by a method as described in claim 1. The electrical characteristics of the power supply circuitry may comprise a supply current flowing through the power supply circuitry, i.e. flowing from the power grid to the coil.

By verifying the electrical characteristics before energising the coil a fault in the connection or a defect in the control device or the chuck can be detected early enough to initiate an appropriate counter measure. The method according to the present invention is proactive in the sense that an erroneous or even dangerous state within the control device or the chuck is detected before a high current of an energising pulse to energise the coil is generated causing an actual risk or damage. As a consequence, the method according to the invention allows a safe operation of both the control device and the chuck and effectively prevents parts of the control device and the chuck from being damaged.

It is provided that the verifying comprises detecting whether the conductor is subjected to a supply voltage of the control device. This allows verifying whether the control device, in particular the power supply circuitry, works correctly. If the coil shall not be energised then under normal circumstances the supply-voltage should not be present at the conductor of the connection between the control device and the chuck. If the supply-voltage is present anyway then an appropriate counter-measure such as inhibiting the energising can be initiated. For example, a counter measure can further comprise automatically disconnecting the control device from the power grid.

In a preferred embodiment of the present invention the method comprises inhibiting the energising depending on the verifying, in particular the method comprises inhibiting the energising if the supply voltage has been detected. Thus, the coil is not energised if the connection is faulty or a part of the control device for the chuck is defective. A high energising current, which is potentially dangerous and can cause damage to the control device or the chuck, is not even applied for a short time if the verifying was not successful. Therefore, the method according to the invention is more effective than a simple overcurrent protection which comes into action only after the high current has been activated.

Preferably, a verifying comprises detecting whether the conductor has a short-circuit to ground, in particular a method comprises inhibiting the energising if the short-circuit to ground has been detected. Energising the coil while there is a short-circuit to ground typically leads to a rapidly increasing current that can destroy electronic parts such as a thyristor of the power supply circuitry or other power electronic parts. Furthermore, the operating personal can be exposed to a high voltage generated by the power supply circuitry, in particular if the control device is not sufficiently connected to a protection earth conductor of a power grid.

It is suggested that the method comprises deactivation of the power supply circuitry such that the electrical connection is de-energised, wherein the deactivation is performed before said detecting whether the conductor has the short-circuit to ground and/or whether the conductor is subjected to the supply voltage. As a consequence, if the parts of the control device are not defective, the verifying is performed when the conductor of the connection is voltage free.

After deactivation of the power supply circuitry, the method according to the present invention may verify whether a supply current flowing through the power supply circuitry is at least essentially zero.

Furthermore, the supply current and/or further electrical characteristics of the power supply circuitry can be monitored while the power supply circuitry is activated. For instance, a mean value and/or a peak value of the supply current can be measured while energising the coil.

According to a preferred embodiment of the present invention is it suggested that the verifying comprises applying a voltage test pulse to the conductor, measuring a current caused by the test pulse and comparing the measured current with a predetermined current. Preferably, the test pulse has a lower amplitude and/or a shorter duration than the energising pulse applied to the coil during energising. Thus, the test pulse has a comparatively low energy so that it cannot lead to any damage of the control device or the chuck and cannot cause a danger for the operating personal. However, the energy of the test pulse is sufficiently high to allow acquiring characteristics of the coil or the chuck by analysing characteristics of the measured current. For instance, the analysed characteristics of the current can comprise a peak current, a momentary current at a given instant, or the progression of the momentary current in time. Measuring the current caused by the test pulse allows verifying whether the right type of chuck is connected to the control device and whether the electrical connection has been established correctly. For example, if a contact resistance of the electrical connection is too high then and it is detected that the connection is faulty. In addition, a short-circuit within the coil can be detected because the short-circuit leads to a high current caused by the test pulse. Preferably, the verifying further comprises inhibiting the energising and/or initiating and/or other counter measures depending on the comparing.

The object is also solved by a control device according to claim 7.

It is preferred, that the verification means comprise verification circuitry having a first circuit arranged to detect whether the conductor has a short-circuit to ground.

It is further preferred, that the verification circuitry comprises a second circuit arranged to detect whether the conductor is subjected to the supply voltage of the control device.

In a preferred embodiment of the present invention the control device comprises control circuitry for controlling the power supply circuitry, wherein the control circuitry is coupled to the first circuit to inhibit energising the coil if the conductor has the short-circuit to ground and/or to the second circuit to inhibit energising if the conductor is subjected to the supply voltage. The control circuitry can be connected to the power supply circuitry. The control circuitry can comprise a micro computer, in particular microcontroller that is programmed to control the power supply circuitry and/or to execute a method according to the present invention. The control circuitry may monitor a signal at outputs of the first circuit and/or the second circuit and initiate the counter measure if the signal indicates that there is a short circuit to ground or that the conductor is subjected to the supply voltage.

Moreover, it is preferred that the power supply circuitry comprises pulse generating means for applying a test pulse to the conductor and that the control device comprises a current sensor for measuring a current caused by the test pulse. This allows the control circuit to acquire characteristics of the coil of the chuck by verifying the current with a predetermined current as described above.

In order to obtain simple and compact power supply circuitry it is suggested that the pulse generating means are connected to at least one control signal generated by the control circuitry and in that the pulse generating means are configured to generate, based on the control signal, either the test pulse to verify the electrical characteristics or an energising pulse to modify the magnetisation of the chuck. Such a control device can have a phase control circuit that can depending on the control signal generate both types of pulses, i.e. the test pulse as well as the energising pulse. The test pulse can be generated by activating the phase control circuit close to a zero-crossing of the supply-voltage, preferably before the zero-crossing of the supply voltage. The energising pulse may comprise a whole half-wave of the supply voltage.

In order to allow that a single control device can be used in connection with multiple chucks in a preferred embodiment of the present invention the electrical connection comprises a first connector of the control device and a second connector of the chuck, wherein a contact loop is closed if the first connector and the second connector are connected to each other and wherein the control circuitry comprises detector means to detect whether the loop is closed. The contact loop further improves reliably and safety of the control device and/or the chuck because the control circuit can keep the power supply circuitry completely deactivated while a chuck is not connected to the control device.

Preferred embodiments and further advantages of the present invention are shown in the figures and described in detail hereinafter.
- Fig. 1: shows a circuit diagram of a control device and a permanently magnetisable chuck according to a preferred embodiment;
- Fig. 2: shows a circuit diagram of verification circuitry of the control device shown in Fig. 1;
- Fig. 3: shows a flow chart of a method to operate the control device shown in Fig. 1;
- Fig. 4: shows diagrams of a supply voltage, a control signal, and a current flowing through a coil of the chuck;
- Fig. 5: shows a detail of a method shown in Fig. 3; and
- Fig. 6: shows a further detail of the method shown in Fig. 3.

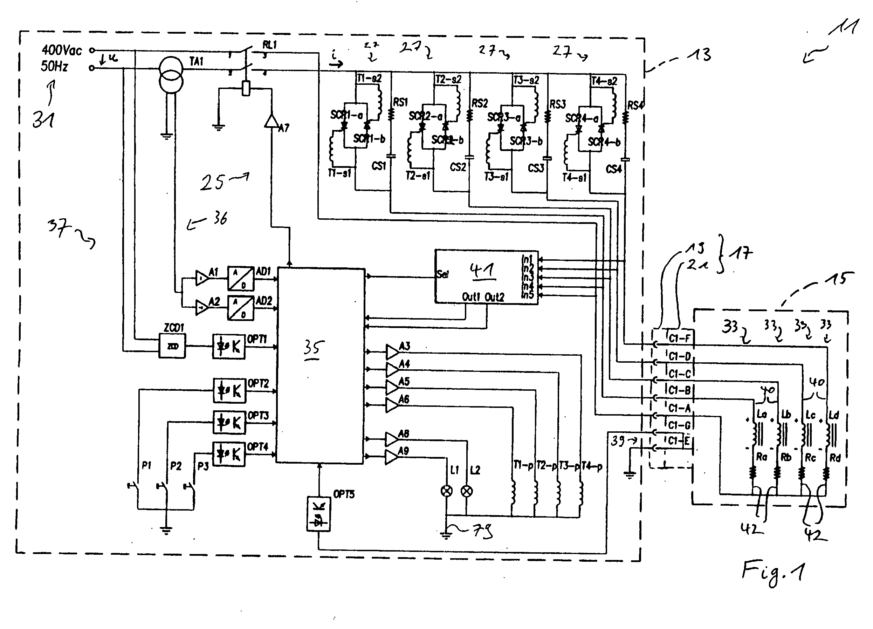

Fig. 1 shows a magnetisable chuck arrangement 11 comprising a control device 13 and a permanently magnetisable chuck 15. The chuck 15 is electrically connected to the control device 13 by means of an electrical connection 17 comprising multiple conductors C1-A to C1-F. The connection 17 comprises a first connector 19 of the control device 13 and a second connector 21 of the chuck 15, wherein the first connector 21 is connected by means of a cable (not shown) to the control device 13, as the second connector 21 is mounted directly on the chuck 15. The electrical connection 17 is detachable so that the control device 13 and the chuck 15 can be removed from each other. This allows using the control device 13 in connection with multiple chucks 15.

The control device 13 has power supply circuitry 25 which comprises four phase control circuits 27 each of them having a pair of anti parallel thyristors SCR1-a and SCR1-b, SCR2-a and SCR2-b, SCR3-a and SCR3-b, SCR4-a and SCR4-b respectively. Each phase control circuit 27 has a serial connection of a resistor RS1, RS2, RS3, RS4 and a capacitor CS1, CS2, CS3, CS4 which form a snubber circuit arranged in parallel to each pair of anti parallel thyristors. In addition, the power supply circuitry 25 comprises a two-pole relay RL1, the two switches of which are connected to a two phase power grid 31.

The chuck 15 comprises four coils 33 an equivalence circuit of which corresponds to a serial connection of an inductor La, Lb, Lc, Ld and a resistor Ra, Rb, Rc, Rd as shown in Fig. 1. Each coil 33 is connected in series with one of the phase control circuits 27. If the fist relay RL1 is in an active state, i.e. both switches of the first relay RL1 are closed, then each coil 33 is connected to the power grid 31 via one phase control circuit 27. If the first relay RL1 is in an inactive state, i.e. if both of the switches of the relay RL1 are open then both the phase control circuits 27 as well as the coils 33 of the chuck 15 are galvanically separated from the power grid 31.

The four coils 33 belong to different sections of the chuck 15. Hence, the chuck shown in Fig. 1 has four sections. In a different embodiment the chuck 15 comprises a different number of sections and coils. The number of phase control circuits 27 of the control device 13 corresponds to the number of coils 33 of the chuck 15.

Furthermore, the control device 13 comprises control circuitry 35 which may comprise a micro computer such as a micro controller. The phase control circuits 27 are coupled to the control circuitry 35 by means of transformers T1, T2, T3, T4, wherein for each phase control circuit 27 an output of the control circuitry 35 is connected to a primary winding T1-p, T2-p, T3-p, T4-p of the transformer via a driver circuit A3, A4, A5, A6. Each transformers T1, T2, T3, T4 has two secondary windings, each of them arranged between a gate and a cathode of one thyristor of the same anti parallel pair of thyristors.

As can be seen in Fig. 1 a primary side of a current transformer TA1 is inserted between the power grid 31 and the first relay RL1. A secondary side of the current transformer TA1 is connected to an input of a first amplifier A1 and an input of a second amplifier A2. The outputs of the amplifiers A1, A2 are connected to inputs of different analogue to digital converters AD1, AD2. An output of each analogue to digital converter AD1, AD2 is connected to the control circuitry 35. The parts TA1, A1, A2, AD1, and AD2 form a current sensor 36, wherein the amplifier A1 and the analogue to digital converter AD1 are arranged to measure a positive current i flowing throw the primary winding of the current transformer TA1, whereas the amplifier A2 and the analogue to digital converter AD2 are arranged to measure a negative current i.

The control device 13 has a zero cross detector ZCT1 for detecting a zero-crossing of a supply voltage u of the control device 13 and for distinguishing a positive half-wave from a negative half-wave of the supply voltage u. Inputs of the zero cross detector ZCT1 are connected to the power grid 31 and outputs of the zero cross detector ZCT1 are connected to the control circuitry 35 by means of an optocoupler OPT1.

Furthermore, the control device 13 comprises three control buttons P1, P2, P3, each of them connected via a different optocoupler OPT2, OPT3, OPT4 to the control circuitry 35. Digital outputs of the control circuitry 35 are connected via two different driver circuits A8, A9 to two indicator lamps L1, L2. Two conductors C1-E and C1-G form a contact loop 39, which is closed if the electrical connection 17 is established, i.e. the first connector 29 and the second connector 21 are connected to each other. A first conductor C1-G of the control loop is connected via an optocoupler OPT5 to the control circuitry 35 and the second conductor C1-E of the control loop 39 is connected to ground within the control device 13.

Moreover, the control device comprises verification circuitry 41. Inputs In1 to In5 of the verification circuitry 41 are connected to different conductors C1-A, C1-B, C1-C, C1-D, C1-F of the electrical connection 17 between the control device 13 and the chuck 15. In particular, four inputs In1, In2, In3, In4 are connected to the different conductors C1-A, C1-B, C1-C, C1-D, C1-F. Each conductor C1-A, C1-B, C1-C, C1-D, C1-F connects a phase control circuit 27 to a first terminal 40 of a single coil 33. Second terminals 42 of the coils 33 are connected to a common conductor C1-A. The common conductor C1-A is connected to the fifth input In5 of the verification circuitry 41. A selection input Sel and two outputs Out1 and Out2 of the verification circuitry 41 are connected to the control circuitry 35.

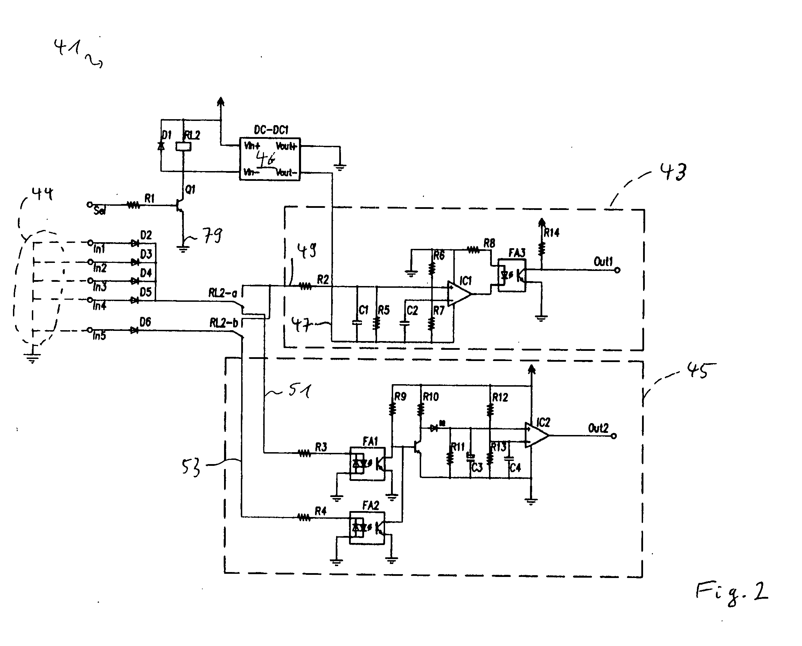

As shown in Fig. 2, the verification circuitry 41 comprises a first circuit 43 to detect whether one of the conductors C1-A, C1-B, C1-C, C1-D and/or C1-F has a short circuit to ground (identified in Fig. 2 with 44). In addition, the verification circuitry 41 comprises a second circuit 45 to detect whether one or more of the conductors C1-A, C1-B, C1-C, C1-D and C1-F are subjected to the supply voltage u of the control device 13, i.e. to detect whether there is a direct or indirect connection between the power grid 31 and at least one of said conductors. A unwanted connection to the supply voltage can be caused by a defective part of one of the phase control circuits 27 such as a defective thyristor or by defective contacts of the first relay RL1 sticking to each other.

The verification circuitry 41 has a second relay RL2 comprising two change-over switches RL2-a, RL2-b. A driver circuit in the form of a grounded emitter circuit comprising a transistor Q1 and a resistor R1 is arranged between the selection input Sel and a coil of the second relay RL2. A free wheeling diode D1 is arranged in parallel to a coil of the second relay RL2. In addition, inputs Vin+ and Vin- of a voltage converter 46 are arranged in parallel to the coil of the second relay RL2. A first output of the voltage converter 46 is grounded and a second output of the voltage converter 46 is connected to a negative supply voltage line 47 of the first circuit 43.

Each input In1 to In5 is connected to a cathode of a different diode D2 to D6. The cathodes of diodes D2, D3, D4, D5 which are connected to one of the inputs In1, In2, In3 or In4 are connected to a common terminal of the first switch RL2-a of the second relay RL2. The cathode of the diode D6 is connected to a common terminal of the second switch RL2-b of the second relay RL2.

If the second relay RL2 is in an active state then the cathodes of all diodes D2 to D6 are connected to an input 49 of the first circuit 43. The first circuit 43 comprises a first comparator IC1 a non-inverting input of which is connected to a centre of a voltage divider comprising at one side a resistor R2 and at another side a parallel circuit consisting of a capacitor C1 and a resistor R5. This voltage divider R2, R5, C1 is arranged between the input 49 and the negative supply voltage line 47, wherein the resistor R2 is connected to the input 49. An inverting input of the comparator IC1 is connected to a centre of a second voltage divider consisting of a resistor R6 connected to ground and a parallel circuit of a capacitor C2 and a resistor R7 connected to the negative supply voltage line 47. A serial connection comprising a resistor R8 and a light emitting diode of an optocoupler FA3 is arranged between ground and an output of the comparator IC1. The optocoupler FA3 comprises a phototransistor an emitter of which is grounded and a collector of which is connected to the first output Out1 and to a pull-up resistor R14.

If the second relay RL2 is in an inactive state then cathodes of the diodes D2 to D5 are connected to a first input 51 of the second circuit 45 and the cathode of the diode D6 is connected to a second input 53 of the second circuit 45. The second circuit comprises an optocoupler FA1. An anode of a light emitting diode of the optocoupler FA1 is connected via resistor R3 to the first input and a cathode of that light emitting diode is grounded. Similar, an anode of a light emitting diode of a further optocoupler FA2 of the second circuit 45 is connected via a further resistor R4 to the second input 53; a cathode of the light emitting diode of the optocoupler FA2 is grounded. Phototransistors of the optocouplers FA1, FA2 are connected in parallel, wherein an emitter of the phototransistors is grounded and the collector of the phototransistors is connected to an input of a transistor stage of the second circuit 45. An output of the transistor stage is connected to a peak detector circuit comprising a diode D2, resistor R11 and a capacitor C3. The peak detector circuit is connected to a non-inverting input of the second comparator IC2. An inverting input of the second comparator IC2 is connected to the centre of a voltage divider, wherein a fist part of the voltage divider comprises a resistor R12 connected to a supply voltage of the second circuit 45 and wherein a second part of the voltage divider comprises a parallel circuit of a resistor R13 and capacitor C4 both connected to ground. An output of the second comparator IC2 corresponds to the second output Out2 of the verification circuitry 41.

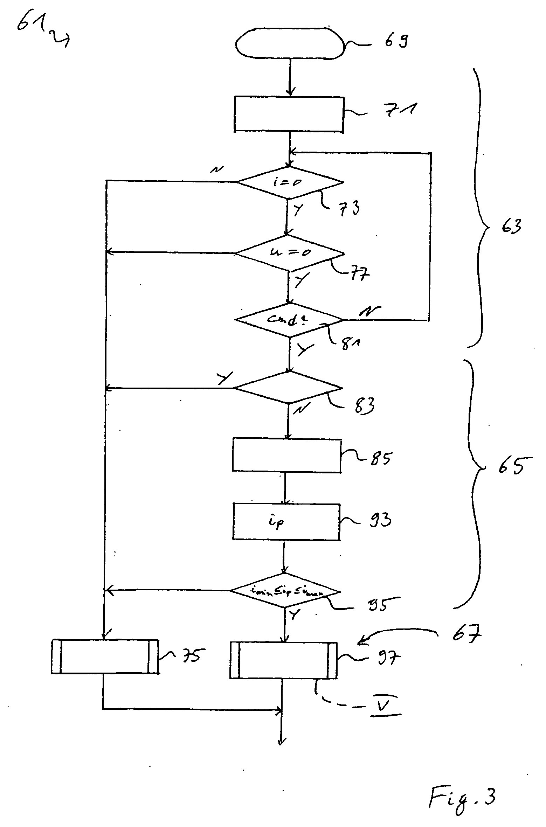

Fig. 3 shows a method 61 to operate the control device 13. This method is executed by the control circuitry 35. If the control circuitry 35 comprises a computer, e.g. a micro controller, then the computer of the control circuitry 35 may be programmed to execute the method 61.

As shown in Fig. 3 the method 61 comprises three modes: a standby mode 63, a preparing mode 65, and an energising mode 67. When in standby mode 63 or in preparing mode 65, the control circuitry 35 verifies electrical characteristics at the conductors C1-A, C1-B, C1-C, C1-D, C1-F of the electrical connection 17 by applying verification means comprising the verifying circuitry 41, the current sensor 36, and the power supply circuitry 25.

When the control device 13 is connected to the power grid 31 then the standby mode 63 is entered after a start 69 of the method 61. In a first step 71 of the standby mode 63 the power supply circuitry 25 is deactivated by setting the first relay RL1 in the inactive state so that its switches are open. Furthermore, in standby mode 63 the control circuitry 35 does not trigger the thyristors of the phase control circuits 27.

Then the control circuitry 35 verifies in a step 73 whether a current i flowing through the power supply circuitry 25 is at least essentially zero. To this end the control circuitry 35 queries the analogue to digital converters AD1, AD2. As the two switches of the first relay RL1 should be open and the thyristors of the phase control circuit 27 should be disabled the current i should be zero. If the current i is not equal to zero (N) then a defect in the first relay and/or in at least one of the phase control circuits 27 is detected and an error handling procedure 75 is called. The error handling procedure 75 may comprise indicating the error to the user of the control device 13 by activating one of the signalling lamps L1 or L2. In addition, the error handling procedure 75 comprises blocking the further operation of the control device 13, in particular inhibiting energising the coils 33 of the chuck 15.

If the current i is at least essentially equal to zero (Y) then the control circuitry 35 executes a step 77 to verify whether at least one of the conductors C1-A, C1-B, C1-C, C1-D and C1-F is subjected to a supply voltage u originating from the power grid 31. The verification step 77 comprises applying a potential which is essentially zero with respect to a ground potential 79 to the selection input Sel of the verification circuitry 41. As a consequence, the second relay RL2 is not energised and the first terminals 40 of the coils 33 are connected via the diodes D2, D3, D4, D5 and the switch RL2-a of the second relay RL2 to the first input 51 of the second circuit 45. The common conductor C1-A is connected via the diode D6 and the switch RL2-b to the second input 53 of the second circuit 45. If at least one of the conductors C1-A, C1-B, C1-C, C1-D and C1-F is subjected to the supply voltage u then the light emitting diode of at least one of the optocouplers FA1, FA2 is activated and the signal according to the potential at the conductors C1-A, C1-B, C1-C, C1-D, C1-F is supplied to the base of the transistor stage of the second circuit 45. The transistor stage amplifies and rectifies the signal and supplies the rectified signal to the non-inverting input of the second comparator IC2.

If an amplitude of the voltage residing at the inputs In1 to In5 of the verification circuitry 41 has a sufficiently high value then a potential at the non-inverting input of the second comparator IC2 is greater than a potential residing at the inverting input of the second comparator IC2 predetermined by the voltage divider R12, R13, C4. Thus, a signal at the second output Out2 of the verification circuitry 41 is in a high state if the inputs In1 to In5 are subjected to the supply voltage u. Otherwise the state of the signal at the second output Out2 is low.

The control circuitry 35 queries the state of the signal at the second output Out2 and continues with the error handling procedure 75 the conductors of the coils are subjected to the supply voltage u. Otherwise the control circuitry 35 continues with a step 81.

In step 81 the control circuitry 35 checks whether the user of the control device 13 has entered a command to energise the coils 33 of the chuck 15 by pressing at least one of the buttons P1, P2 or P3. To this end, the control circuitry 35 is polling signals generated by the optocouplers OPT2, OPT3 and/or OPT4. If the user has not entered a command (N) then the method 61 branches back to step 73.

If the user has entered a command (Y) then the method 61 switches over to the preparing mode (65) and a further verification step 83 is performed in order to detect whether at least one of the conductors C1-A, C1-B, C1-C, C1-D, and C1-F has the short circuit to ground 44. The further verification step 83 comprises applying a positive potential with respect to the ground potential 79 to the selection input Sel of the verification circuitry 41 so that the transistor Q1 is activated and both the second relay RL2 and the voltage converter 46 are energised. Both the conductors C1-B, C1-C, C1-D, C1-F connected to the first terminals 40 as well as the common conductor C1-A connected to the second terminals 42 of all coils 33 are connected via the diodes D2 to D6 and the activated switches RL2-a, RL2-b of the second relay RL2 to the input 49 of the first circuit 43. If there is no short-circuit to ground then a potential at the non-inverting input of the first comparator IC1 is less than a potential at the inverting input of the first comparator IC1 predetermined by the voltage divider R6, R7, C2. This causes the first comparator IC1 to apply a current to the serial connection of the resistor R8 and the light emitting diode of the optocoupler FA3. Hence, the optocoupler FA3 pulls a signal at the first output Out1 of the verification circuitry 41 to ground (low state) if no short-circuit to ground 44 is detected.

However, if there is a short-circuit to ground, then the voltage divider R2, R5, C1 causes the potential at the non-inverting input of the first comparator IC1 to increase and eventually to become greater than the potential at the inverting input of the first comparator IC1. Then the first comparator IC1 deactivates the light emitting diode of the optocoupler FA3 and the signal at the first output Out1 changes to a high state.

The verification circuitry 35 queries the state of the signal at the first output Out1 and detects depending on the queried state whether there is a short circuit to ground. If so (Y) then the error handling procedure 75 is executed, otherwise (N) the method 61 goes on with a pulse generating step 85.

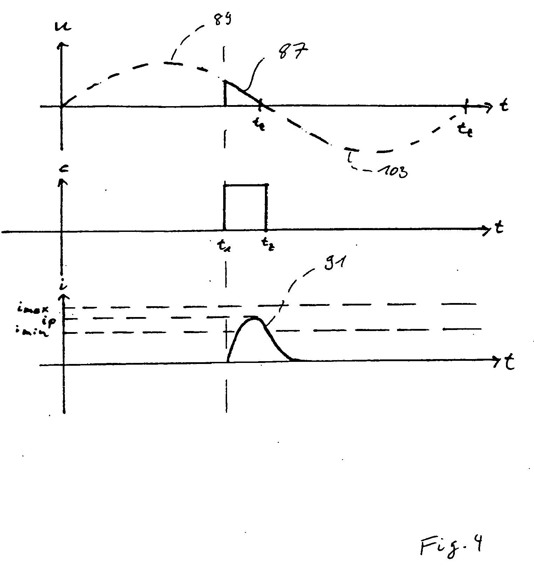

In step 85 a test pulse 87 shown in Fig. 4 is generated which has a low energy compared with a half wave of the supply voltage u. The test pulse 87 is generated by accordingly controlling the phase control circuits 27. The control means 35 generate a control pulse c that is amplified by the driver circuits A3, A4, A5, A6 and supplied to the primary windings T1-p, T2-p, T3-p, T4-p of the transformers between the control section and the phase control circuits 27 of the power supply circuitry 25. A duration of the control pulse residing at an end of a positive half wave 89 of the supply voltage u corresponds to 20 % of a duration of the half wave 89. The control pulse c is deactivated at a zero crossing point t_{z} of the supply voltage u. In order to achieve that timing of the control pulse the control circuitry 35 uses an input signal generated by the zero crossing detector ZCD1 and galvanically separated by the optocoupler OPT1 to determine a start time t₁ of the control pulse.

If the chuck 15 is connected to the control device 13 then the test pulse 87 causes a current pulse 91 of the supply current i. In a step 93 executed after step 85 a peak current iₚ of the current pulse 91 is determined by continuously measuring the current i by querying the analogue to digital converters AD1, AD2 at least between the instances tₗ und t_{z} and calculating the maximum value iₚ of the measured current i.

In a subsequent step 95 the control circuitry 35 verifies whether the peak current iₚ is within a valid range bounded by a minimum tolerable peak current iₘᵢₙ and a maximum tolerable peak current iₘₐₓ. If the peak current is within the valid range then the method 61 enters the energising mode 67 which comprises an energising procedure 97. Otherwise the error handling procedure 75 is performed. Verifying the peak current iₚ allows detecting a short-circuit within the coil 33 because such a short-circuit leads to an intolerable high peak current iₚ > iₘₐₓ.

After the energising procedure 97 or the error handling procedure 75 has been completed the method 61 begins again with step 71.

The control circuitry 35 is checking whether the contact loop 39 is closed by querying the signal at the output of optocoupler OPT5. If the contact loop 39 is not closed then the control circuitry 35 prevents the method 61 from being started and/or cancels the already started method 61.

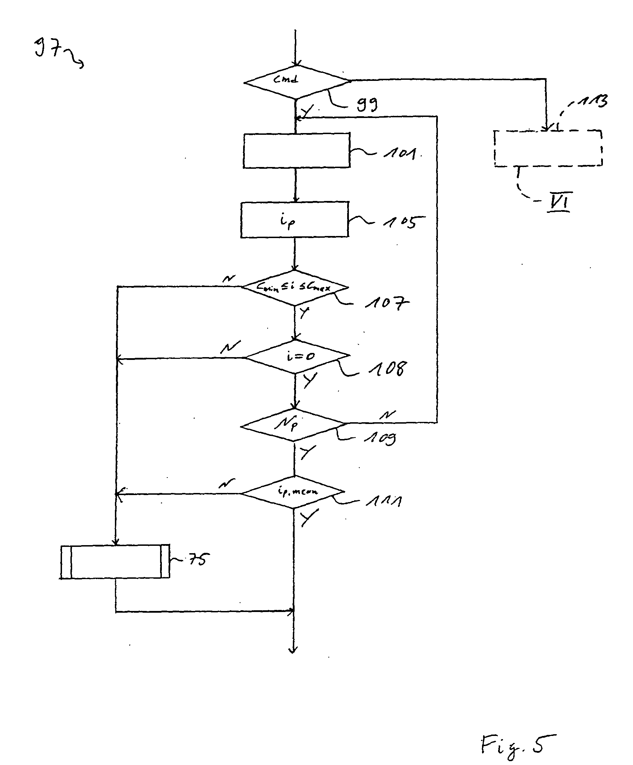

Details of the energising procedure 97 are shown in Fig. 5. In a step 99 the control circuitry 35 determines whether the command which the user has entered by means of the buttons P1, P2, P3 corresponds to a magnetisation command. If the command corresponds to a magnetisation command (Y) then, in a step 101, the control circuitry 35 controls the phase control circuit 27 to generate an energising pulse. An energy of the energising pulse is considerably higher than the energy of the test pulse 87. For instance, the energy pulse can be generated by activating the phase control circuit 27 at the beginning of the half wave 89, 103 of the supply voltage u so that the energising pulse comprises essentially the whole half wave. By activating the phase control circuits 27 either at the beginning of the positive half wave 89 or at the beginning of a negative half wave 103 a direction of magnetisation of the chuck 15 can be controlled.

In a subsequent step 105 the peak current iₚ during the energising pulse is measured by means of the current sensor 36. Then in a step 107 it is verified whether a momentary value of the current i is within an valid range (Cₘᵢₙ, Cₘₐₓ) during an appropriate interval within the duration of the energising pulse. The interval may be less than the duration of the energising pulse. If this is not the case (N) then the error handling procedure 75 is performed.

In a subsequent step 108 the method 61 verifies whether the momentary value of the supply current i has become zero after the end of the energising pulse, i.e. after the zero crossing of the supply voltage u has been detected by the zero crossing detector ZCT1. If the momentary value of the supply current i is not zero (N) then the error handling procedure 75 is executed.

Otherwise (Y) a step 109 checks whether a predetermined number Nₚ of energising pulses has been applied. If so (Y) then the method 61 continues with a step 111, otherwise (N) the method 61 goes back to step 101.

Step 111 serves to check whether a mean value i_{p,mean} of the determined peak current iₚ is within a predetermined appropriate range. If the mean peak value i_{p,mean} is not within that appropriate range (N) then the error handling procedure 75 is performed otherwise (Y) the energising procedure 97 is terminated.

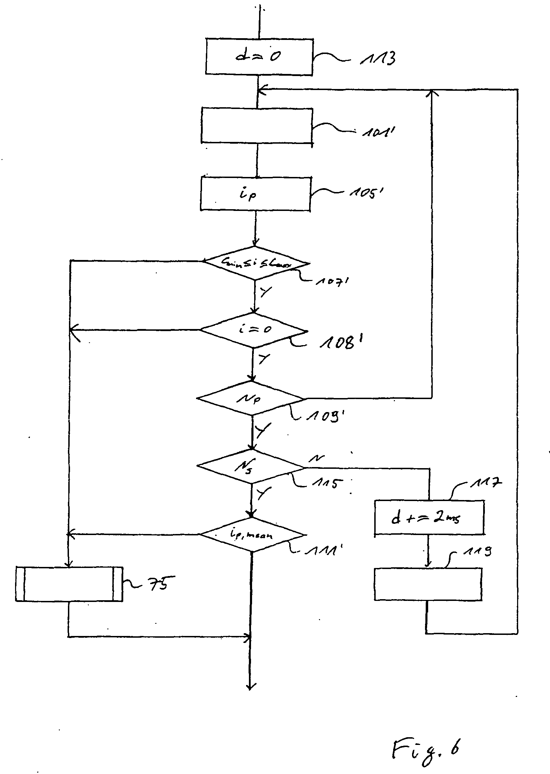

If the command is a demagnetisation command, then step 99 branches to a step 113 shown in Fig. 6 that sets a phase control delay d between the zero crossing point and an instance of activation of the phase control circuits 27 to the value d = 0. Then the steps 101' to 109' are performed in order to apply the number Nₚ of energising pulses to the coils 33. The steps 101' to 109' correspond to the steps 101 to 109 described above. The energy of the energising pulse depends on the delay d. The less is the delay d the higher is the energy of the energising pulse.

After step 109' a step 115 checks whether the loop comprising the steps 101' to 111' has been executed Nₛ-times. If not, then in a step 117 the delay d is increased. For example, as shown in Fig. 6, the delay can be increased by two milliseconds. In a subsequent step 119 the polarity of the energy pulse to be applied next is inverted with respect to a polarity of the previously applied energy pulse. Then the method 61 goes back to step 101'.

If the number of iterations of the loop 101' to 115' has reached the predetermined value Nₛ then a step 111' is executed to which corresponds to the above described step 113 to check the mean peak current i_{p,mean}. Finally, the energising procedure 97 is terminated.

The demagnetisation sequence shown in Fig. 6 applies a series of Nₛ bursts of Nₚ energising pulses, wherein the energising pulses of each burst have the same energy, i.e. delay d, and the same polarity. However, the energy of the energising pulses of consecutive bursts decreases because after a burst has been applied to the coils 33 the delay d is increased in step 117. Furthermore, the polarities of the energising pulses of adjacent bursts differ from each other.

In another embodiment, a different type of chuck 15 is used. To magnetise this type of chuck 15 at least one first energising pulse of a given polarity, preferably a positive energising pulse, is applied to the coils 33. For demagnetising the chuck 15 at least one second energising pulse, preferably a negative energising pulse, is applied to the coils 33, i.e. the polarities of the first energising pulse to magnetise the chuck 15 and the polarity of the second energising pulse 33 to demagnetise the chuck differ from each other. When using said different type of chuck 15 then the steps 101 to 111 shown in Fig. 5 are used to generate both the first energising pulse as well as the second energising pulse.

To sum up, the method 61 performs the steps shown in Fig. 3 in order to prevent parts of the arrangement 11 from being damaged by performing several checks at the electrical connection 17 in order to verify that the electrical connection 17 is correctly established with the correct type of chuck 15 comprising non-defective coils 33 with expected electrical properties. If the connection 17 is faulty, e.g. if there is a short circuit between the conductors of the connection 17, then the energising procedure 97 is not executed. The energy of the test pulse 87 generated in step 85 is so low that parts of the arrangement 11, in particular the thyristors of the phase control circuit 27 or the switches of the first relay RL1 cannot be damaged by the current i caused by the test pulse 91 in any case. The tests performed in steps 107, 107' 109, 109', 111, 111', 113, 113' during the energising procedure 97 performed to monitor the energising procedure 97 in order to detect that the chuck 15 has been magnetised or demagnetised incorrectly and to generate a corresponding alarm message.

## Claims

1. Method (61) to operate a control device (13) for energising (97) at least one coil (33) of a permanently magnetisable chuck (15) to modify a magnetisation of the chuck (15),
wherein the control device (13) comprises an electrical connection (17) having at least one conductor (C1-A, C1-B, C1-C, C1-D, C1-F) to connect power supply circuitry (25) of the control device (13) with the coil (33),
the method (61) comprising energising (97) the coil by means of said power supply circuitry (25) to modify the magnetisation,
wherein the method (61) further comprises verifying (63, 65, 73) electrical characteristics at the at least one conductor (C1-A, C1-B, C1-C, C1-D, C1-F) and/or electrical characteristics (i) of the power supply circuitry (25), wherein said verifying (63, 65) is performed before said energising (97), **characterised in that** the verifying (63, 65) comprises detecting (77) whether the conductor (C1-A, C1-B, C1-C, C1-D, C1-F) is subjected to a supply voltage (u) of the control device (13).

2. Method (61) according to claim 1, **characterised in that** the method (61) comprises inhibiting (75) the energising (97) depending on the verifying (63, 65), in particular the method (61) comprises inhibiting (75) the energising (97) if the supply voltage (u) has been detected.

3. Method (61) according to claim 1 or 2, **characterised in that** the verifying (63, 65) comprises detecting (83) whether the conductor (C1-A, C1-B, C1-C, C1-D, C1-F) has a short-circuit to ground (44), in particular the method (61) comprises inhibiting (75) the energising (97) if the short-circuit to ground (44) has been detected.

4. Method (61) according to claims 1 to 3, **characterised in that** the method (61) comprises deactivation (71) of the power supply circuitry (25) such that the electrical connection (17) is de-energised, wherein the deactivation (71) is performed before said detecting (83) whether the conductor has the short-circuit to ground (44) and/or whether the conductor (C1-A, C1-B, C1-C, C1-D, C1-F) is subjected to the supply voltage (u).

5. Method (61) according to claim 4, **characterised in that** the method (61) comprises verifying (73) whether a supply current (i) flowing through the deactivated power supply circuitry (25) is at least essentially zero.

6. Method (61) according to one of the precedent claims, **characterised in that** the verifying (63, 65) comprises applying (85) a voltage test pulse (87) to the conductor (C1-A, C1-B, C1-C, C1-D, C1-F), measuring (93) a current (i) caused by the test pulse (87) and comparing (95) the measured current (ip) with a predetermined current (iₘᵢₙ, iₘₐₓ).

7. Control device (13) suitable for energising (97) at least one coil (33) of a permanently magnetisable chuck (15), comprising power supply circuitry (25) for energising (97) the coil (33) in order to modify a magnetisation of the chuck (15) and an electrical connection (17) having at least one conductor (C1-A, C1-B, C1-C, C1-D, C1-F) to connect the power supply circuitry (25) with the coil (33), wherein the control device (13) further comprises verification means (35, 36, 41) for verifying electrical characteristics at the at least one conductor (C1-A, C1-B, C1-C, C1-D, C1-F) and/or electrical characteristics (i) of the power supply circuitry (25) before said energising (97), wherein the control device (13) is configured to execute a method (61) according to claims 1 to 6.

## Patentansprüche

1. Verfahren (61) zum Betreiben einer Steuervorrichtung (13) zum Erregen wenigstens einer Spule (33) eines permanent magnetisierbaren Spannfutters (15), um eine Magnetisierung des Spannfutters (15) zu ändern, wobei die Steuervorrichtung (13) eine elektrische Verbindung (17) mit wenigstens einem Leiter (C1-A, C1-B, C1-C, C1-D, C1-F) zur Verbindung einer Stromversorgungsschaltung (25) der Steuervorrichtung (13) mit der Spule (33) umfasst, wobei das Verfahren (61) die Erregung (97) der Spule mittels der Stromversorgungsschaltung (25) zur Änderung der Magnetisierung umfasst, wobei das Verfahren (61) ferner das Verifizieren (63, 65, 73) elektrischer Eigenschaften am wenigstens einen Leiter (C1-A, C1-B, C1-C, C1-D, C1-F) und/oder elektrischer Eigenschaften (i) der Stromversorgungsschaltung (25) umfasst, wobei das Verifizieren (63, 65) vor dem Erregen (97) durchgeführt wird, **dadurch gekennzeichnet, dass** das Verifizieren (63, 65) das Erkennen (77) ob der Leiter (C1-A, C1-B, C1-C, C1-D, C1-F) einer Versorgungsspannung (u) der Steuervorrichtung (13) ausgesetzt ist umfasst.

2. Verfahren (61) nach Anspruch 1, **dadurch gekennzeichnet, dass** das Verfahren (61) die Hemmung (75) der Erregung (97) in Abhängigkeit des Verifizierens (63, 65), insbesondere die Hemmung (75) der Erregung (97) bei Detektion der Versorgungsspannung (u), umfasst.

3. Verfahren (61) nach Anspruch 1 oder 2, **dadurch gekennzeichnet, dass** das Verifizieren (63, 65) das Erkennen (83) ob der Leiter (C1-A, C1-B, C1-C, C1-D, C1-F) einen Massekurzschluss (44) hat, insbesondere die Hemmung (75) der Erregung (97) bei Erkennung des Massekurzschlusses (44), umfasst.

4. Verfahren (61) nach einem der Ansprüche 1 bis 3, **dadurch gekennzeichnet, dass** das Verfahren (61) die Deaktivierung (71) der Stromversorgungsschaltung (25) umfasst, so dass die elektrische Verbindung (17) stromlos ist, wobei die Deaktivierung (71) vor dem Erkennen (83) ob der Leiter den Massekurzschluss hat und/oder ob der Leiter (C1-A, C1-B, C1-C, C1-D, C1-F) der Versorgungsspannung ausgesetzt ist, durchgeführt wird.

5. Verfahren (61) nach Anspruch 4, **dadurch gekennzeichnet, dass** das Verfahren (61) das Verifizieren (73), ob ein Versorgungsstrom (i), welcher durch die deaktivierte Stromversorgungsschaltung (25) fließt, zumindest im Wesentlichen null ist, umfasst.

6. Verfahren (61) nach einem der vorhergehenden Ansprüche, **dadurch gekennzeichnet, dass** das Verifizieren (63, 65) das Anlegen (85) eines Spannungstestimpulses (87) an den Leiter (C1-A, C1-B, C1-C, C1-D, C1-F), das Messen (93) eines durch den Testimpuls (87) hervorgerufenen Stroms (i) und das Vergleichen (95) des gemessenen Stroms (iₚ) mit einem vorgegebenen Stromwert (iₘᵢₙ, iₘₐₓ) umfasst.

7. Steuervorrichtung (13) zum Erregen (97) wenigstens einer Spule (33) eines permanent magnetisierbaren Spannfutters (15), umfassend eine Stromversorgungsschaltung (25) zum Erregen (97) der Spule (33), um eine Magnetisierung des Spannfutters (15) zu ändern, und eine elektrische Verbindung (17) mit wenigstens einem Leiter (C1-A, C1-B, C1-C, C1-D, C1-F) zur Verbindung der Stromversorgungsschaltung (25) mit der Spule (33), wobei die Steuervorrichtung (13) ferner Verifikationsmittel (35, 36, 41) zur Verifikation elektrischer Eigenschaften am wenigstens einen Leiter (C1-A, C1-B, C1-C, C1-D, C1-F) und/oder elektrischer Eigenschaften (i) der Stromversorgungsschaltung (25) vor der Erregung (97) umfasst, wobei die Steuervorrichtung (13) dafür ausgelegt ist, ein Verfahren nach einem der Ansprüche 1 bis 6 auszuführen.

## Revendications

1. Procédé (61) de fonctionnement d'un dispositif de contrôle (13) pour alimenter (97) au moins une bobine (33) d'un mandarin magnétisable en permanence (15) pour modifier une magnétisation du mandrin (15),
dans lequel le dispositif de contrôle (13) comprend une connexion électrique (17) ayant au moins un conducteur (C1-A, C1-B, C1-C, C1-D, C1-F) permettant de connecter les circuits d'alimentation électrique (25) du dispositif de contrôle (13) avec la bobine (33),
le procédé (61) comprenant l'alimentation (97) de la bobine au moyen desdits circuits d'alimentation électrique (25) afin de modifier la magnétisation,
dans lequel le procédé (61) comprend en outre la vérification (63, 65, 73) des caractéristiques électriques au niveau du au moins un conducteur (C1-A, C1-B, C1-C, C1-D, C1-F) et/ou les caractéristiques électriques (i) des circuits d'alimentation électrique (25), dans lequel ladite vérification (63, 65) est effectuée avant ladite alimentation (97), **caractérisé en ce que** la vérification (63, 65) comprend la détection (77) permettant de savoir si le conducteur (C1-A, C1-B, C1-C, C1-D, C1-F) est soumis à une tension d'alimentation (u) du dispositif de contrôle 13.

2. Procédé (61) selon la revendication 1, **caractérisé en ce que** le procédé (61) comprend l'interdiction (75) de l'alimentation (97) en fonction de la vérification (63, 65), en particulier le procédé (61) comprend l'interdiction (75) de l'alimentation (97) si la tension d'alimentation (u) a été détectée.

3. Procédé (61) selon la revendication 1 ou 2, **caractérisé en ce que** la vérification (63, 65) comprend la détection (83) permettant de savoir si le conducteur (C1-A, C1-B, C1-C, C1-D, C1-F) a un court-circuit à la terre (44), en particulier le procédé (61) comprend l'interdiction (75) de l'alimentation (97) si le court-circuit à la terre (44) a été détecté.

4. Procédé (61) selon les revendications 1 à 3, **caractérisé en ce que** le procédé (61) comprend la désactivation (71) des circuits d'alimentation électrique (25) de telle sorte que la connexion électrique (17) ne soit plus alimentée, dans lequel la désactivation (71) est effectuée avant ladite détection (83) permettant de savoir si le conducteur présente un court circuit à la terre (44) et/ou si le conducteur (C1-A, C1-B, C1-C, C1-D, C1-F) est soumis à la tension d'alimentation (u).

5. Procédé (61) selon la revendication 4, **caractérisé en ce que** le procédé (61) comprend la vérification (73) permettant de savoir si un courant d'alimentation (i) circulant à travers les circuits d'alimentation électrique (25) désactivés est au moins essentiellement égal à zéro.

6. Procédé (61) selon l'une des revendications précédentes, **caractérisé en ce que** la vérification (63, 65) comprend l'application (85) d'une impulsion d'essai de tension (87) au conducteur (C1-A, C1-B, C1-C, C1-D, C1-F), la mesure (93) d'un courant (i) résultant de l'impulsion d'essai (87) et la comparaison (95) du courant mesuré (ip) à un courant prédéterminé (iₘᵢₙ, iₘₐₓ).

7. Dispositif de contrôle (13) pour alimenter (97) au moins une bobine (33) d'un mandarin magnétisable en permanence (15), comprenant des circuits d'alimentation électrique (25) pour alimenter (97) la bobine (33) afin de modifier une magnétisation du mandrin (15) et une connexion électrique (17) ayant au moins un conducteur (C1-A, C1-B, C1-C, C1-D, C1-F) pour connecter les circuits d'alimentation électrique (25) et la bobine (33), dans lequel le dispositif de contrôle (13) comprend en outre des moyens de vérification (35, 36, 41) permettant de vérifier les caractéristiques électriques au niveau du au moins un conducteur (C1-A, C1-B, C1-C, C1-D, C1-F) et/ou les caractéristiques électriques (i) des circuits d'alimentation électrique (25) avant ladite alimentation (97), dans lequel le dispositif de contrôle (13) est configuré pour exécuter un procédé (61) selon les revendications 1 à 6.
